# DEMANDE DE BREVET EUROPEEN

(11) **EP 0 957 575 A1**
(43) Date de publication de la demande: **17.11.1999**
(21) Numéro de dépôt: 99401146.8
(22) Date de dépôt: 10.05.1999
(51) Int. Cl.: H03F 3/60

(54) **Amplificateur de puissance à encombrement réduit pour circuit micro-ondes**

(30) Priorité: 14.05.1998 FR 9806084
(71) Demandeur: ALCATEL, 75008 Paris (FR)
(72) Inventeur: Loval, Lucien, 59139 Wattignies (FR); Sarkissian, Jean-Claude, 92150 Suresnes (FR); Soulard, Michel, 95370 Montigny Les Cormeilles (FR)
(74) Mandataire: Lamoureux, Bernard

(57) **Abrégé**

L'invention concerne un amplificateur de puissance pour circuit micro-ondes, comprenant une pluralité de transistors (31-34) sensiblement alignés; selon l'invention, les bus de grille de deux transistors voisins sont reliés par l'intermédiaire d'un circuit d'adaptation de grille (36, 37, 38), et les réseaux de drain de deux transistors voisins sont reliés par l'intermédiaire d'un circuit d'adaptation de drain (40, 41, 42); les circuits d'adaptation de grille sont choisis de sorte à assurer des niveaux d'entrée identiques en amplitude et en phase sur chaque transistor, et les circuits d'adaptation de drain sont choisis de sorte à présenter à chaque transistor l'impédance optimale en puissance.

L'entrée de l'amplificateur se trouve sur le bus de grille d'un transistor (31) à l'extrémité du montage série des transistors, et la sortie sur le réseau de drain d'un transistor (34) à l'autre extrémité du montage série des transistors.

On peut ainsi assembler dans un amplificateur de puissance un nombre quelconque de transistors, en formant un amplificateur dans une surface réduite.

## Description

La présente invention concerne les circuits micro-ondes, et plus particulièrement ceux réalisés en technologie monolithique intégrée, ou technologie MMIC (acronyme de l'anglais monolithic microwave integrated circuit). Plus précisément, elle concerne un circuit d'amplification à encombrement réduit en technologie MMIC.

La technologie MMIC est couramment utilisée pour la réalisation de circuits micro-ondes, pour le traitement des signaux micro-ondes ou signaux dans des plages de fréquences typiques de 1 à 50 GHz et plus.

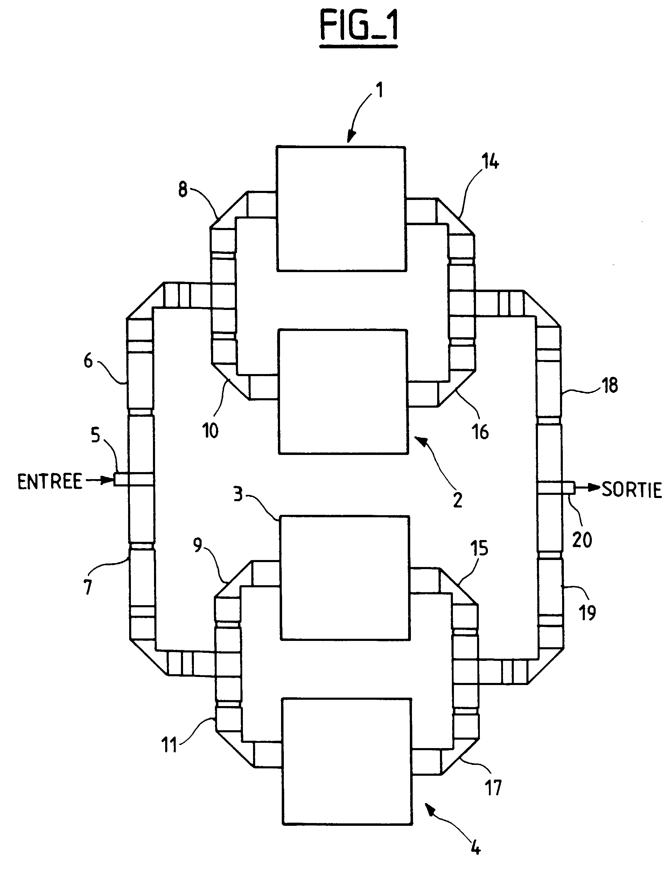

La figure 1 montre un exemple d'un amplificateur de puissance connu, en technologie MMIC. L'amplificateur de la figure 1 comprend quatre transistors 1 à 4, fonctionnant en parallèle et qui sont attaqués par des circuits diviseurs de tension symétriques; ils fournissent en sortie des signaux à des circuits combineurs de tension qui sont aussi symétriques. Dans l'exemple de la figure 1, l'amplificateur présente en entrée deux étages de diviseurs, et en sortie deux étages de combineurs. Le signal d'entrée à amplifier est appliqué à une borne d'entrée 5, et est divisé en deux signaux égaux en amplitude et en phase, dans les deux branches 6 et 7. Les signaux de chacune des branches sont eux mêmes séparés en deux signaux identiques, qui sont appliqués aux bus de grille des transistors 1 à 4. Plus précisément, les signaux sur la branche 6 sont séparés en des signaux sur des branches 8 et 10, appliqués aux bus de grille des transistors 1 et 2; les signaux sur la branche 7 sont séparés en des signaux sur des branches 9 et 11, appliqués aux bus de grille des transistors 3 et 4. En sortie des transistors, le montage est symétrique par rapport à la ligne formée par les transistors. Les signaux fournis par les réseaux de drain des transistors 1 et 2 sur les branches 14 et 16 sont combinés et transmis sur une branche 18, tandis que les signaux fournis par les réseaux de drain des transistors 15 et 17 sont combinés et transmis sur une branche 19. Les signaux des branches 18 et 19 sont combinés et constituent le signal de sortie sur la borne 20.

Le montage de la figure 1 présente l'avantage d'une grande simplicité de conception, et d'une division comme d'une combinaison aisée des signaux. Toutefois, il présente l'inconvénient de ne pouvoir s'adapter qu'à un nombre de transistors égal à une puissance entière de 2 - quatre transistors dans l'exemple de la figure 1. Ceci peut conduire à des difficultés dans le dimensionnement des différents transistors formant le circuit. En outre, le circuit de la figure 1 occupe une surface importante sur le support de circuit.

L'invention a pour objet de résoudre le problème de l'encombrement des circuits d'amplification réalisés en technologie MMIC. Elle a aussi pour objet de résoudre le problème de l'assemblage d'un nombre quelconque de transistors.

Plus précisément, l'invention propose un amplificateur de puissance pour signaux micro-ondes comprenant une pluralité de transistors identiques, caractérisé en ce que les bus de grille de deux transistors voisins sont reliés par l'intermédiaire d'un circuit d'adaptation de grille, en ce que les réseaux de drain de deux transistors voisins sont reliés par l'intermédiaire d'un circuit d'adaptation de drain, en ce que les circuits d'adaptation de grille sont choisis de sorte à assurer des niveaux d'entrée identiques en amplitude et en phase sur chaque transistor, et en ce que les circuits d'adaptation de drain sont choisis de sorte à présenter à chaque transistor l'impédance optimale en puissance.

Dans un mode de réalisation, l'amplificateur présente une borne d'entrée sur le bus de grille d'un transistor; il peut présenter une borne de sortie sur le réseau de drain d'un transistor.

Avantageusement, l'amplificateur est réalisé en technologie MMIC.

D'autres caractéristiques et avantages de l'invention apparaîtront à la lecture de la description qui suit de modes de réalisation de l'invention, donnée à titre d'exemple et en référence aux dessins annexés qui montrent:
- figure 1 une représentation schématique d'une partie d'un amplificateur en technologie MMIC à quatre transistors, selon l'art antérieur;
- figure 2 une représentation schématique d'un amplificateur en technologie MMIC à quatre transistors, selon l'invention;

L'invention propose, dans un amplificateur de puissance en technologie MMIC, de disposer les transistors sensiblement alignés, comme dans le montage de l'art antérieur; toutefois, à l'inverse de ce montage, elle propose de relier par des circuits d'adaptation respectifs les bus de grille d'une part, et les réseaux de drain d'autre part des transistors voisins. Un choix approprié des circuits d'adaptation permet alors une entrée de l'amplificateur sur le bus de grille d'un transistor à un extrémité du circuit, et une sortie sur le réseau de drain à l'autre extrémité du circuit.

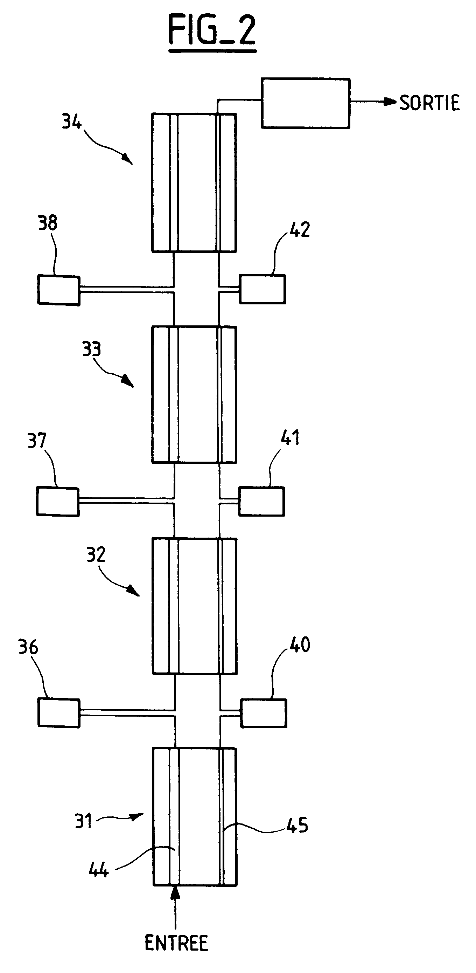

La figure 2 montre une représentation schématique d'un amplificateur en technologie MMIC à quatre transistors, selon l'invention. Le choix de quatre transistors, comme dans l'exemple de la figure 1, permet une comparaison plus aisée avec l'art antérieur, mais n'est pas limitatif de l'invention.

L'amplificateur de la figure 2 comprend quatre transistors 31 à 34, montés en source commune et fonctionnant en série. Les bus de grille de deux transistors voisins sont reliés par un circuit d'adaptation d'impédance et de phase; les circuits 36, 37 et 38 sont respectivement disposés entre les bus de grille des transistors 31 et 32, 32 et 33, et 33 et 34. Les réseaux de drain de deux transistors voisins sont reliés par un circuit d'adaptation d'impédance et de phase; les circuits 40, 41 et 42 sont respectivement disposés entre les réseaux de drain des transistors 31 et 32, 32 et 33, et 33 et 34. Les références 44 et 45 indiquent respectivement, pour le transistor 31, les bus de grille et de drain.

L'entrée de l'amplificateur se trouve avantageusement sur le bus de grille d'un transistor situé à une extrémité du montage série des transistors. Dans l'exemple de la figure 2, l'entrée de l'amplificateur se trouve sur le bus de grille du transistor 31. La sortie de l'amplificateur peut se trouver sur le réseau de drain d'un transistor situé à l'autre extrémité du montage série des transistors - dans l'exemple de la figure 2 la sortie se trouve sur le réseau de drain du transistor 34 situé à l'autre extrémité de l'alignement de transistors.

Les circuits d'adaptation de grille 36, 37 et 38 sont choisis de sorte que les transistors 31 à 34 de l'amplificateur soient attaqués de la même façon, en amplitude comme en phase. On peut ainsi, comme dans le montage de l'art antérieur, utiliser des transistors identiques.

Les circuits d'adaptation de drain 40, 41 et 42 sont choisis de sorte à adapter l'impédance de sortie de chaque transistor et à assurer une combinaison en phase des puissances fournies en sortie des transistors. On assure ainsi que chacun des transistors fonctionne de façon optimale dans l'amplificateur, i. e. en conformité avec ses propres spécifications; la combinaison en phase des puissances fournies par chaque transistor assure un rendement optimal de l'amplificateur dans son ensemble.

La réalisation des circuits d'adaptation de grille et des circuits d'adaptation de drain s'effectue de façon connue en soi par synthèse de réseau; une telle réalisation est à la portée de l'homme du métier. Une telle synthèse assure le résultat - une attaque identique des différents transistors en amplitude et en phase pour des circuits d'adaptation de grille, et une adaptation d'impédance des transistors comme une combinaison en phase des puissances pour les circuits d'adaptation de drain.

Par rapport au montage de la figure 1, le montage de la figure 2 permet une gain de surface de l'ordre de 20%; ce gain de place provient notamment de l'absence de combineurs dans le circuit de la figure 2.

L'invention assure ainsi une meilleure intégration, et permet de réduire le prix des circuits comprenant l'amplificateur. L'augmentation de la densité d'intégration permet une réduction corrélative du coût de l'intégration.

Bien entendu, la présente invention n'est pas limitée aux exemples et modes de réalisation décrits et représentés, mais elle est susceptible de nombreuses variantes accessibles à l'homme de l'art. Ainsi, l'invention permet à l'évidence de constituer un amplificateur de puissance à partir d'un nombre quelconque de transistors; il suffit dans ce cas comme expliqué en référence à la figure 2, de choisir des circuits d'adaptation assurant des niveaux d'entrée identiques en amplitude et en phase sur chaque transistor, ainsi que des circuits d'adaptation en sortie permettant de présenter à chaque transistor l'impédance optimale en puissance.

On a décrit l'invention dans le cadre d'une technologie MMIC. Elle pourrait aussi être mise en oeuvre en technologie hybride, les réseaux d'adaptation et/ou les transistors étant rapportés sur un substrat.

## Revendications

1. Un amplificateur de puissance pour signaux micro-ondes comprenant une pluralité de transistors identiques (31-34), caractérisé en ce que les bus de grille de deux transistors voisins sont reliés par l'intermédiaire d'un circuit d'adaptation de grille (36, 37, 38), en ce que les réseaux de drain de deux transistors voisins sont reliés par l'intermédiaire d'un circuit d'adaptation de drain (40, 41, 42), en ce que les circuits d'adaptation de grille sont choisis de sorte à assurer des niveaux d'entrée identiques en amplitude et en phase sur chaque transistor, et en ce que les circuits d'adaptation de drain sont choisis de sorte à présenter à chaque transistor l'impédance optimale en puissance.

2. Un amplificateur selon la revendication 1, caractérisé en ce qu'il présente une borne d'entrée sur le bus de grille d'un transistor (31).

3. Un amplificateur selon la revendication 1 ou 2, caractérisé en ce qu'il présente une borne de sortie sur le réseau de drain d'un transistor (34).

4. Un amplificateur selon la revendication 1, 2 ou 3, caractérisé en ce qu'il est réalisé en technologie MMIC.
